# EUROPÄISCHE PATENTSCHRIFT

(11) **EP 1 051 535 B1**
(45) Veröffentlichungstag und Bekanntmachung des Hinweises auf die Patenterteilung: **05.12.2001**
(21) Anmeldenummer: 99907245.7
(22) Anmeldetag: 18.01.1999
(51) Int. Cl.: C23C 16/00

(54) **SUBSTRATHALTERUNG FÜR SiC-EPITAXIE UND VERFAHREN ZUM HERSTELLEN EINES EINSATZES FÜR EINEN SUSZEPTOR**
SUBSTRATE SUPPORT FOR SiC EPITAXY AND METHOD FOR PRODUCING AN INSERT FOR A SUSCEPTOR
SUPPORT DE SUBSTRAT DESTINE A L'EPITAXIE DU SiC ET PROCEDE PERMETTANT DE FABRIQUER UN INSERT DESTINE A UN SUSCEPTEUR

(30) Priorität: 29.01.1998 DE 19803423
(43) Veröffentlichungstag der Anmeldung: 15.11.2000
(73) Patentinhaber: SiCED Electronics Development GmbH & Co KG, 91052 Erlangen (DE)
(72) Erfinder: RUPP, Roland, D-91207 Lauf (DE); WIEDENHOFER, Arno, D-91058 Erlangen (DE)
(74) Vertreter: Zedlitz, Peter, Dipl.-Inf.
(86) Internationale Anmeldenummer: DE9900097
(87) Internationale Veröffentlichungsnummer: WO9939022

(56) Entgegenhaltungen:
- DE-A1- 2 826 943
- DE-A1- 3 114 467
- DE-A1- 3 837 584

## Beschreibung

Die Erfindung betrifft eine Vorrichtung zum Haltern eines Substrats, die einen Suszeptor als Unterlage für das zu beschichtende Substrat umfaßt, sowie ein Verfahren zum Herstellen eines Einsatzes für einen solchen Suszeptor.

Das Aufwachsen von einer einkristallinen Schicht erfolgt bei Siliciumcarbid bei sehr viel höheren Temperaturen als bei anderen Halbleitern wie Silicium oder Galliumarsenid. Daher besteht ein Hauptproblem bei der Siliciumcarbid-Epitaxie in der Wahl eines geeigneten Materials als Unterlage und Befestigung des SiC-Wafers. Grund hierfür ist zum einen die hohe Prozeßtemperatur zwischen 1300°C und 2000°C und zum anderen die Notwendigkeit, einen Wasserstoffpartialdruck in der Prozeßkammer von etwa 10 kPa (0,1 atm) aufrecht zu erhalten, um ein einkristallines Wachstum mit akzeptablen Wachstumsraten (> 1 µ/h) zu ermöglichen. Außerdem muß eine Reaktion des Materials, das in direkten Kontakt zum SiC-Substrat steht, mit diesem Substrat verhindert werden.

Aufgrund dieser Anforderungen werden beim Stand der Technik als Materialien beschichteter und unbeschichteter Graphit sowie Werkstoffe aus Übergangsmetallen verwendet.

Aus der DE 38 37 584 A1 ist eine beschichtete Substrathalterung bekannt. Auf die Oberfläche eines Kohlenstoffbasismaterials ist dabei eine SiC-Schicht aufgebracht.

Unbeschichteter Graphit ist formstabil und chemisch völlig inert gegenüber SiC. Selbst bei sehr hohen Temperaturgradienten kommt es zu keiner Rißbildung durch thermische Spannungen.

Bei der genannten hohen Prozeßtemperatur von 1300 bis 1600°C und einem Wasserstoffpartialdruck von etwa 10 kPa kommt es jedoch zu einer Reaktion mit dem Wasserstoff unter Bildung von Kohlenwasserstoffen. Auch wenn die Abtragsraten in der Größenordnung von 1 µm/h sind, verschieben diese Kohlenwasserstoffe das durch die verwendeten Prozeßgase wie z.B. Silan, Propan vorgegebene Verhältnis von Kohlenstoff zu Silicium im Bereich der Substratoberfläche hin zu Überschuß an Kohlenstoff. Dieser Effekt ist ortsabhängig und erzeugt Inhomogenitäten im Substrat. Weiterhin werden im Graphit enthaltene Verunreinigungen freigesetzt (Al, Ti, B) und in die Epitaxieschicht eingebaut. Eine Verschlechterung der Eigenschaften dieser Schicht sind die Folge.

Um hier Abhilfe zu schaffen, wurden in den letzten Jahren verstärkt Graphitteile für die Halterung des Wafers verwendet, die mit Siliciumcarbid (SiC) beschichtet sind. Eine Reaktion des Wasserstoffs mit dem Graphit kann dadurch verhindert werden, daß diese Beschichtung gasdicht gemacht wird.

Andererseits führt die Beschichtung zu einer deutlichen Verschlechterung der mechanischen Eigenschaften der Teile. Temperaturgradienten in den mechanischen Teilen können zu Rissen in der Beschichtung und sogar zu einem Brechen des gesamten Teils führen. Auch nicht durchgängige Risse führen bei der üblicherweise verwendeten induktiven Heizung zu einer unkontrollierbaren Beeinflussung der Temperaturverteilung.

Darüber hinaus besteht das Problem, daß es durch den Kontakt des Wafers mit einer mit SiC beschichteten Oberfläche zu einem unerwünschten Aufwachsen von SiC kommt. Dieses Problem wird durch die hohen Prozeßtemperaturen verstärkt. Der Transportvorgang erfolgt insbesondere von der Unterlage zur Rückseite des Wafers.

Ebenso ist aus der Literatur die Verwendung von Übergangsmetallen wie Mo und Ta als Suszeptor für die SiC-Epitaxie bekannt. Beide Übergangsmetalle besitzen einen niedrigen Dampfdruck und werden vom Wasserstoff nicht angegriffen. Wie Graphit ertragen diese Metalle hohe thermische Spannungen.

Die Diffusionskonstanten von Verunreinigungen in diesen Metallen sind jedoch hoch, so daß z.B. in den Übergangsmetallen enthaltenes A1 durch diesen Vorgang in die Prozeßatmosphäre gelangen und die Eigenschaften der Epitaxieschicht verschlechtern kann. Beide Metalle bilden außerdem Silicide und Carbide, es kommt somit zu einer Reaktion mit der Waferrückseite bzw. mit den Spaltprodukten des Silan und Propan. Damit ändern sich zeitabhängig die optische Eigenschaften der Materialoberfläche. Da der Wärmetransport bei den hohen Prozeßtemperaturen zu einem wesentlichen Teil über Strahlung erfolgt, ergeben sich daraus wiederum unerwünschte Rückwirkungen auf die Temperaturverteilung der Waferauflage. Ta besitzt weiterhin die Neigung, bei hohen Temperaturen Wasserstoff in seinem Kristallgitter einzulagern, was bei einem raschen Abkühlprozeß zu einer Zerstörung des Werkstücks führt. Üblicherweise muß daher der Abkühlprozeß bei etwa 1000° für ca. 1 h angehalten werden und die H-Atmosphäre z.B. durch Ar ausgetauscht werden. Dies führt zu einer unerwünschten Verlängerung des Gesamtprozesses und höheren Kosten.

Es ist die Aufgabe der vorliegenden Erfindung, eine Substrathalterung zu schaffen, die eine Kontaminierung des Substrats bei der Bearbeitung, z.B. bei einer Erzeugung einer Epitaxieschicht auf dem Wafer, ausschließt, sowie ein Herstellungsverfahren dafür anzugeben.

Diese Aufgabe wird gelöst durch eine Vorrichtung zum Haltern eines Substrats mit den Merkmalen nach Anspruch 1 und ein Verfahren zum Herstellen eines Einsatzes für einen Suszeptor nach Anspruch 11. Die Unteransprüche beziehen sich auf bevorzugte Ausführungsformen der Erfindung.

Die Erfindung beruht darauf, zumindest Teile der Hilfsmaterialien, die sich beim SiC-Epitaxieprozeß im Bereich hoher Temperatur befinden, durch Metallcarbide zu ersetzen. Dazu wird vorgeschlagen, die Oberfläche der Teile, die mit dem SiC-Substrat unter den genannten Umgebungsbedingungen in Berührung kommen, zu versiegeln, d.h. gasdicht zu beschichten, so daß von den Teilen kein kontaminierendes Material über die Oberfläche in das Substrat eingebaut werden (diffundieren) kann. Hierbei sind solche hochtemperaturstabilen Carbide zu wählen, die sowohl gegenüber Wasserstoff inert sind als sich auch gegenüber SiC im chemischen Gleichgewicht befinden. Weiterhin darf der Carbid-Bildner keine elektrisch aktive Verunreinigung im SiC sein (Al- und Borcarbid scheiden daher aus). Besonders geeignet sind: TaC, MoC, NbC, WC.

Die erfindungsgemäße Vorrichtung zum Haltern eines Substrats, die einen Suszeptor als Unterlage für das zu beschichtende Substrat umfaßt, ist dadurch gekennzeichnet, daß der Suszeptor einen Einsatz umfaßt, dessen Oberfläche wenigstens teilweise mit einer Metallcarbid-Schicht vorgegebener Dicke bedeckt ist.

Vorzugsweise ist der Einsatz so aufgebaut, daß er in seinem Querschnitt eine "sandwich"-Struktur aufweist, d.h. er besteht aus einem Kern, vorzugsweise aus Graphit oder einem Metall, der mit der Metallcarbid-Schicht bedeckt ist.

Die Dicke der Metallcarbid-Schicht auf dem Einsatz kann mit dem Abstand vom Wafer sinken. Damit ist vor allem die Oberfläche in der direkten Umgebung des Wafers versiegelt, so daß es zu keiner Diffusion kontaminierenden Materials zu dem Wafer von Teilen kommt, die direkt mit diesem in Berührung kommen. Dadurch werden auch die Herstellungskosten der entsprechenden, mit dem Wafer in Berührung kommenden Teile gesenkt.

Vorzugsweise besteht die Metallcarbid-Schicht aus TaC, MoC, NbC oder WC.

Der Einsatz kann mehrere Kacheln für jeweils ein Substrat umfassen, wobei jede Kachel darüber hinaus eine Vertiefung für ein Substrat aufweisen kann.

Das erfindungsgemäße Herstellungsverfahren für Einsätze mit einer Oberflächenschicht aus Metallcarbiden beruht auf dem Tempern einer in SiC-Pulver eingebetteten Vorform zwischen 1500°C und 2000°C und der anschließenden Hartbearbeitung zur endgültigen Formgebung. Mit diesem Prozeß wird ein Verbundwerkstoff erzeugt, der aus einer je nach Temperbedingungen mehr oder weniger dicken Carbid-Oberflächenschicht und noch nicht carbidisiertem Metall im Inneren besteht. Die Korngrenzen in diesem Metall sind dabei ebenfalls zumindest teilweise carbidisiert.

Das erfindungsgemäße Verfahren zum Herstellen eines Einsatzes für einen Suszeptor mit einer Oberflächenschicht aus Metallcarbid umfaßt die Schritte Erzeugen einer metallischen Vorform, Einbetten der metallischen Vorform in ein kohlenstoffhaltiges Pulver, Aufheizen der metallischen Vorform und des kohlenstoffhaltiges Pulvers auf eine erhöhte Temperatur, Hartbearbeiten der getemperten Vorform und Anordnen der hartbearbeiteten Vorform an dem Suszeptor als Einsatz.

Vorzugsweise liegt bei dem Verfahren die erhöhte Temperatur zwischen 1500°C und 2000°C und erfolgt das Aufheizen unter erhöhtem Druck.

Das kohlenstoffhaltige Pulver umfaßt insbesondere Siliciumcarbid-Pulver.

Die Erfindung hat die folgenden Vorteile. Es kommt zu keiner Reaktion der Waferumgebung mit dem SiC sowie mit dem Prozeßgas der Epitaxie wie z.B. Propan, Silan und Wasserstoff.

Damit wird die Reinheit der Epitaxieschicht verbessert und eine höhere Lebensdauer des Werkstücks erreicht. Die mechanischen Eigenschaften der Substrathalterkomponenten sind gut, da Carbide an sich spröde sind, durch den duktilen metallischen Kern die Gesamtform jedoch stabilisiert wird und damit eine größere Flexibilität beim Design von Suszeptor, Probenhalter usw. möglich ist. Außerdem wird die Diffusion in den Carbiden gegenüber den Metallen stark reduziert. Als "Diffusionsbremsen" wirken insbesondere die Korngrenzen im metallischen Gefüge. Damit wird eine verbesserte Reinheit der Epitaxieschicht erreicht. Schließlich wird die Einlagerung von Wasserstoff in das Kristallgitter unterbunden, wodurch eine rationelle Prozeßführung ermöglicht wird.

Die Erfindung wird im folgenden zum besseren Verständnis anhand zeichnerisch dargestellter Ausführungsbeispiele erläutert, wobei Bezug genommen wird auf die beigefügten Zeichnungen.
- Figur 1: zeigt eine Ausführungsform des erfindungsgemäßen Graphit-Suszeptors mit Carbid-Einsatz im Querschnitt.
- Figur 2: zeigt im Querschnitt das Gefüge eines mit dem erfindungsgemäßen Verfahren hergestellten Einsatzes für den Graphit-Suszeptor nach Figur 1.
- Figur 3: zeigt eine Ausführungsform des erfindungsgemäßen Einsatzes für eine Multiwafer-Epitaxieanlage im Aufriß.

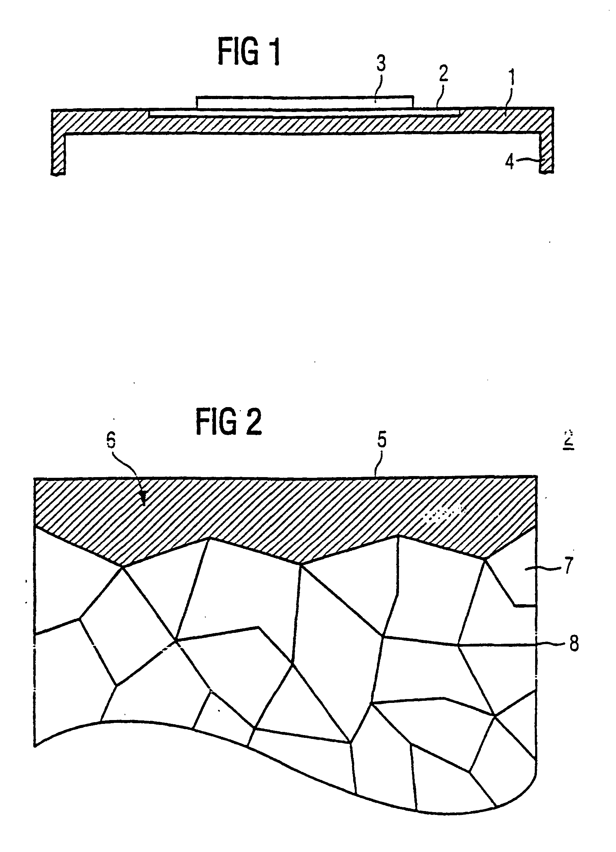

Figur 1 stellt im Querschnitt eine bevorzugte Ausführungsform des erfindungsgemäßen Suszeptors 1 dar. Vorzugsweise wird der Suszeptor 1 aus Graphit hergestellt, damit er optimale Wärmeleitfähigkeit besitzt und für eine Induktionsheizung (mit Wirbelstrom) die entsprechenden optimalen elektrischen Eigenschaften aufweist. Die genaue Form des Suszeptors 1 kann ohne Einschränkung durch die Erfindung an den Ofen angepaßt werden. So kann der Suszeptor 1 Verlängerungen 4 aufweisen, die als Gestell zur Befestigung in einem (nicht dargestellten) Ofen dienen. Die Verlängerungen 4 an der Seite des Suszeptors 1 in Figur 1 können aus demselben Material wie der Suszeptor 1 bestehen und mit diesem einstückig verbunden sein oder aus einem anderen Material geformt sein und mit dem Suszeptor 1 formschlüssig verbunden sein.

Auf einer Oberseite weist der Suszeptor 1 erfindungsgemäß eine Vertiefung für einen Einsatz 2 auf. Diese Vertiefung dient zur Aufnahme einer oder mehrerer Kacheln oder Einsätze 2, auf denen jeweils ein Wafer oder ein Substrat 3 aus einem Halbleitermaterial liegt. Insbesondere, aber nicht ausschließlich ist, wie oben bereits erläutert, die erfindungsgemäße Vorrichtung zur Halterung eines Substrats für Halbleitermaterialien geeignet, die bei sehr hohen Temperaturen bearbeitet werden müssen, wie SiC etc.. Die Verarbeitung des Substrats aus SiC kann z.B. das epitaxiale Aufwachsen von SiC auf dem Substrat beinhalten.

Der erfindungsgemäße Einsatz 2 in dem Suszeptor 1 muß einerseits einer sehr hohen Temperaturbelastung standhalten und darf andererseits nicht durch die H-Atmosphäre in seinen Eigenschaften beeinträchtigt werden. Erfindungsgemäß besteht der Einsatz 2 daher aus einem temperaturstabilen Carbid, das gegenüber Wasserstoff inert ist und sich mit SiC im chemischen Gleichgewicht befindet.

Damit durch das Kation im Carbid keine Verunreinigung in das Siliciumcarbid eingebracht wird, scheiden einige Metalle als Carbid-Kationen aus, insbesondere A1 und B, die sonst in das SiC diffundieren oder in die Epitaxieschicht eingebaut werden und als Akzeptoren wirken könnten. Vorzugsweise werden daher als Kationen des Carbids Tantal, Molybdän, Niob, Wolfram und weitere Nebengruppenelemente wie Cr, Hf, V etc. eingesetzt.

Bei einer bevorzugten Ausführungsform der Erfindung wird der Einsatz 2 durch Sintern oder Tempern eines Gemisches aus Metallpulver und Kohlenstoff hergestellt. Unter Druck und bei hoher Temperatur kommt es in dem Pulvergemisch zu einer Carburierung. Ein Querschnitt durch den so gewonnenen Verbundwerkstoff ist als Teil des Einsatzes 2 in Figur 2 gezeigt. Die Oberfläche 5 des Einsatzes 2 wird im wesentlichen durch Carbid 6 gebildet, während tiefer in dem Einsatz 2 das Metall in Form metallischer Gefügekörner 7 vorliegt. Die metallischen Körner 7 weisen jeweils eine Korngrenze 8 auf, an der das Metall ebenfalls wenigstens teilweise carbidisiert ist.

Bei einer anderen bevorzugten (nicht dargestellten) Ausführungsform der Erfindung wird eine "Sandwich"-Struktur als Einsatz verwendet, bei der die Oberfläche eine Schicht aus Metallcarbid ist, die mit einer anderen Technik als der in dem obigen Absatz beschriebenen aufgebracht wird (z.B. Abscheidung aus der Gasphase etc.), und bei der der Kern des Einsatzes 2 ein Graphit-Körper oder ein Metallkörper ist. Diese Ausführungsform hat den Vorteil, daß die Formgebung des Einsatzes 2 einfacher ist als bei der obigen Herstellung mittels Sintern oder Tempern des gesamten Einsatzes.

Insbesondere kann bei der letztgenannten Struktur die Dicke der Schicht aus Metallcarbid besonders einfach eingestellt werden, so daß vor allem die Teile in unmittelbarer Nähe des Wafers versiegelt sind. Als Kern des Einsatzes 2 kommen wiederum verschiedene Materialien in Frage, wie z.B. Graphit, Metalle wie Mo, W, Hf usw. und weitere Verbundmaterialien, die den Anforderungen an Temperatur und chemischer Belastung standhalten.

Das erfindungsgemäße Verfahren zum Herstellen eines Suszeptors mit einer Oberflächenschicht aus Metallcarbid beruht auf dem Tempern bzw. Sintern einer in SiC-Pulver eingebetteten Vorform, vorzugsweise bei einer Temperatur zwischen 1500°C und 2000°C, und der anschließenden Hartbearbeitung zur endgültigen Formgebung. Mit diesem Prozeß wird ein Verbundwerkstoff erzeugt, der aus einer je nach Temperbedingungen mehr oder weniger dicken Carbid-Oberflächenschicht und noch nicht carbidisiertem Metall im Inneren besteht.

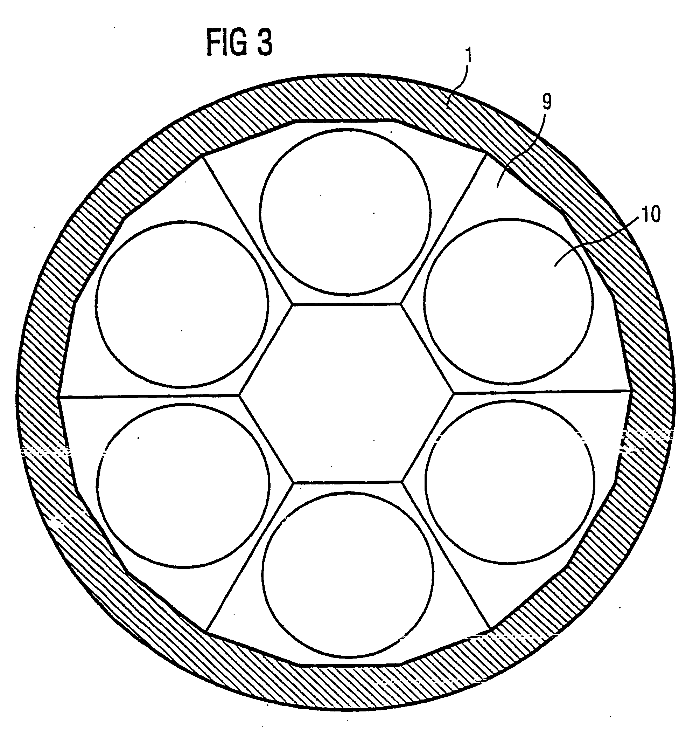

Figur 3 zeigt eine Ausführungsform eines erfindungsgemäßen Einsatzes in seiner Gesamtgröße. Im Außenbereich ist der Suszeptor 1 dargestellt. Der Einsatz 2 setzt sich aus mehreren Kacheln 9 zusammen, die alle im wesentlichen eine solche Form haben, daß ein (nicht dargestellter) Wafer 3 auf ihnen Platz findet. In der dargestellten Ausführungsform des Einsatzes 2 ist dieser für 6 Wafer ausgelegt. Der Suszeptor 1 wird um eine Achse, die durch die Mitte des Suszeptors 1 in Figur 3 senkrecht zur Zeichenebene verläuft, gedreht. Die Rotation kann je nach Bearbeitungsschritt der Wafer 3 mit höherer Geschwindigkeit erfolgen, u. a. um einen stabilen Gasstrom in der (nicht dargestellten) Kammer oder dem Ofen bei der Bearbeitung zu gewährleisten. Damit die Wafer 3 bei der Drehung einen definierten Abstand zueinander einhalten und nicht verrutschen, ist in jeder Kachel 9 eine Vertiefung 10 vorgesehen, deren Durchmesser dem Durchmesser eines Wafers entspricht. Damit ist der in Figur 3 dargestellte Einsatz 2 für Multiwafer-Epitaxieanlage besonders geeignet.

Ein weiterer Vorteil der Ausführungsform nach Figur 3 liegt darin, daß definierte Umgebungsbedingungen für die Wafer geschaffen werden können. Eine Kombination der Carbide mit Graphit oder auch Metallen wie Ta, Mo, W beim Gesamtaufbau ist nämlich insbesondere in der heißen Zone eines Epireaktors wünschenswert und im chemischen Gleichgewicht möglich. Da für den Verunreinigungseintrag insbesondere die direkte Umgebung des Wafers kritisch ist, werden vorzugsweise dort die Carbide eingesetzt. Durch die Vertiefung 10 in den Kacheln 9 kann so verhindert werden, daß der Wafer 3 verrutscht und an einen Ort gelangt, bei dem weniger Carbide vorliegen, so daß es zu einer Kontamination des Wafers kommen kann.

## Patentansprüche

1. Vorrichtung zum Haltern eines Substrats, die einen Suszeptor (1) als Unterlage für das zu beschichtende Substrat (3) umfaßt, **dadurch gekennzeichnet, daß** der Suszeptor (1) einen Einsatz (2) umfaßt, dessen Oberfläche (5) wenigstens teilweise mit einer Metallcarbid-Schicht (6) vorgegebener Dicke bedeckt ist.

2. Vorrichtung nach Anspruch 1, **dadurch gekennzeichnet, daß** der Einsatz (2) mehrere Kacheln (9) für jeweils ein Substrat (3) umfaßt.

3. Vorrichtung nach Anspruch 2, **dadurch gekennzeichnet, daß** jede Kachel (9) eine Vertiefung (10) für ein Substrat (3) aufweist.

4. Vorrichtung nach einem der Ansprüche 1 bis 3, **dadurch gekennzeichnet, daß** der Einsatz (2) einen Graphit-Kern umfaßt, der mit der Metallcarbid-Schicht (6) bedeckt ist.

5. Vorrichtung nach einem der Ansprüche 1 bis 3, **dadurch gekennzeichnet, daß** der Einsatz (2) einen Metall-Kern (7) umfaßt, der mit der Metallcarbid-Schicht (6) bedeckt ist.

6. Vorrichtung nach einem der vorangehenden Ansprüche, **dadurch gekennzeichnet, daß** die Dicke der Metallcarbid-Schicht (6) mit dem Abstand vom Wafer (3) sinkt.

7. Vorrichtung nach einem der Ansprüche 1 bis 6, **dadurch gekennzeichnet, daß** die Metallcarbid-Schicht (6) für den Einsatz (2) Tantalcarbid umfaßt.

8. Vorrichtung nach einem der Ansprüche 1 bis 6, **dadurch gekennzeichnet, daß** die Metallcarbid-Schicht (6) für den Einsatz (2) Niobcarbid umfaßt.

9. Vorrichtung nach einem der Ansprüche 1 bis 6, **dadurch gekennzeichnet, daß** die Metallcarbid-Schicht (6) für den Einsatz (2) Wolframcarbid umfaßt.

10. Vorrichtung nach einem der Ansprüche 1 bis 6, **dadurch gekennzeichnet, daß** die Metallcarbid-Schicht (6) für den Einsatz (2) Molybdaencarbid umfaßt.

11. Verfahren zum Herstellen eines Einsatzes (2) für einen Suszeptor (1) mit einer Oberflächenschicht (6) aus Metallcarbid, **gekennzeichnet durch** die Schritte: Erzeugen einer metallischen Vorform,
Einbetten der metallischen Vorform in ein kohlenstoffhaltiges Pulver,
Aufheizen der metallischen Vorform und des kohlenstoffhaltigen Pulvers auf eine erhöhte Temperatur, Hartbearbeiten der getemperten Vorform,
Anordnen der hartbearbeiteten Vorform an dem Suszeptor (1) als Einsatz (2).

12. Verfahren nach Anspruch 11, **dadurch dadurch gekennzeichnet, daß** das Aufheizen unter erhöhtem Druck erfolgt.

13. Verfahren nach Anspruch 11 oder 12, **dadurch gekennzeichnet, daß** die erhöhte Temperatur zwischen 1500°C und 2000°C liegt.

14. Verfahren nach einem der Ansprüche 11 bis 13, **dadurch gekennzeichnet, daß** das kohlenstoffhaltige Pulver Siliciumcarbid-Pulver umfaßt.

## Claims

1. Device for mounting a substrate, which device comprises a susceptor (1) as a support for the substrate (3) to be coated, **characterized in that** the susceptor (1) comprises an insert (2), whose surface (5) is at least partly covered with a metal carbide layer (6) of predetermined thickness.

2. Device according to Claim 1, **characterized in that** the insert (2) comprises a plurality of tiles (9) each for one substrate (3).

3. Device according to Claim 2, **characterized in that** each tile (9) has a depression (10) for a substrate (3).

4. Device according to one of Claims 1 to 3, **characterized in that** the insert (2) comprises a graphite core covered with the metal carbide layer (6).

5. Device according to one of Claims 1 to 3, **characterized in that** the insert (2) comprises a metal core (7) covered with the metal carbide layer (6).

6. Device according to one of the preceding claims, **characterized in that** the thickness of the metal carbide layer (6) decreases with the distance from the wafer (3).

7. Device according to one of Claims 1 to 6, **characterized in that** the metal carbide layer (6) for the insert (2) comprises tantalum carbide.

8. Device according to one of Claims 1 to 6, **characterized in that** the metal carbide layer (6) for the insert (2) comprises niobium carbide.

9. Device according to one of Claims 1 to 6, **characterized in that** the metal carbide layer (6) for the insert (2) comprises tungsten carbide.

10. Device according to one of Claims 1 to 6, **characterized in that** the metal carbide layer (6) for the insert (2) comprises molybdenum carbide.

11. Method for producing an insert (2) for a susceptor (1) with a surface layer (6) made of metal carbide, **characterized by** the steps of:
producing a metallic preform,
embedding the metallic preform in a carbon-containing powder,
heating the metallic preform and the carbon-containing powder to an elevated temperature,
hard processing the heat-treated preform,
arranging the hard-processed preform on the susceptor (1) as an insert (2).

12. Method according to Claim 11, **characterized in that** the heating is effected under elevated pressure.

13. Method according to Claim 11 or 12, **characterized in that** the elevated temperature lies between 1500°C and 2000°C.

14. Method according to one of Claims 11 to 13, **characterized in that** the carbon-containing powder comprises silicon carbide powder.

## Revendications

1. Dispositif de maintien d'un substrat qui comprend un suscepteur (1) servant de support au substrat (3) à revêtir, **caractérisé en ce que** le suscepteur (1) comporte un insert (2) dont la surface (5) est revêtue au moins partiellement d'une couche (6) de carbure métallique d'une épaisseur donnée à l'avance.

2. Dispositif suivant la revendication 1, **caractérisé en ce que** l'insert (2) comporte plusieurs carreaux (9) pour respectivement un substrat (3).

3. Dispositif suivant la revendication 2, **caractérisé en ce que** chaque carreau (9) comporte une cavité (10) pour un substrat (3).

4. Dispositif suivant l'une des revendications 1 à 3, **caractérisé en ce que** l'insert (2) comprend une âme en graphite qui est revêtue de la couche (6) de carbure métallique.

5. Dispositif suivant l'une des revendications 1 à 3, **caractérisé en ce que** l'insert (2) comprend une âme (7) métallique qui est revêtue de la couche (6) de carbure métallique.

6. Dispositif suivant l'une des revendications précédentes, **caractérisé en ce que** l'épaisseur de la couche (6) de carbure métallique diminue au fur et à mesure qu'augmente la distance à la pastille (3).

7. Dispositif suivant l'une des revendications 1 à 6, **caractérisé en ce que** la couche (6) de carbure métallique pour l'insert (2) comprend du carbure du tantale.

8. Dispositif suivant l'une des revendications 1 à 6, **caractérisé en ce que** la couche (6) de carbure métallique pour l'insert (2) comprend du carbure de niobium.

9. Dispositif suivant l'une des revendications 1 à 6, **caractérisé en ce que** la couche (6) de carbure métallique pour l'insert (2) comprend du carbure de tungstène.

10. Dispositif suivant l'une des revendications 1 à 6, **caractérisé en ce que** la couche (6) de carbure métallique pour l'insert (2) comprend du carbure de molybdène.

11. Procédé de fabrication d'un insert (2) pour un suscepteur (1) ayant une couche (6) superficielle en carbure métallique, **caractérisé par** les stades :
production d'une ébauche métallique,
incorporation de l'ébauche métallique dans une poudre carbonacée,
chauffage de l'ébauche métallique et de la poudre carbonacée à une haute température,
traitement de l'ébauche ayant subi la trempe afin de lui donner de la dureté,
mise de l'ébauche ayant reçu de la dureté sur le suscepteur (1) en tant qu'insert (2).

12. Procédé suivant la revendication 11, **caractérisé en ce qu'**il consiste à effectuer le chauffage sous haute pression.

13. Procédé suivant la revendication 11 ou 12, **caractérisé en ce que** la température haute est comprise entre 1500°C et 2000°C.

14. Procédé suivant la revendication 11 à 13, **caractérisé en ce que** la poudre carbonacée comprend de la poudre de carbure de silicium.
